# EUROPEAN PATENT APPLICATION

(11) **EP 4 768 781 A1**
(43) Date of publication of application: **01.07.2026**
(21) Application number: 24896730.9
(22) Date of filing: 29.11.2024
(51) Int. Cl.: F21V 13/08, F21V 9/40, F21Y 115/30

(54) **LIGHT SOURCE**

(30) Priority: 01.12.2023 CN 202311655729
(71) Applicant: YLX Incorporated, Shenzhen, Guangdong 518000 (CN)
(72) Inventor: CHEN, Bin, Shenzhen, Guangdong 518000 (CN); WANG, Qishu, Shenzhen, Guangdong 518000 (CN)
(74) Representative: Luppi Intellectual Property S.r.l.
(86) International application number: PCT/CN2024/135716
(87) International publication number: WO 2025/113650

(57) **Abstract**

A light source (1), comprising: an excitation light source (10) and a wavelength conversion apparatus (20). The excitation light source (10) comprises a housing (110), a laser chip (120), and a light beam guiding element (130). The housing (110) forms a packaging cavity (140). The packaging cavity (140) is provided with a light outlet (150). The laser chip (120) and the light beam guiding element (130) are provided in the packaging cavity (140). The laser chip (120) is used for emitting a laser beam. The light beam guiding element (130) is used for guiding the laser beam towards the light outlet (150). The wavelength conversion apparatus (20) is spaced apart from the housing (110) and corresponds to the light outlet (150). The wavelength conversion apparatus (20) and the excitation light source (10) are separately arranged, and the housing (110) of the excitation light source (10) and the wavelength conversion apparatus (20) are spaced apart, so that the wavelength conversion apparatus (20) can be easily maintained and replaced, so as to avoid waste by discarding the entire light source (1).

## Description

### TECHNICAL FIELD

The present disclosure relates to the technical field of projection equipment, and in particular, to a light source.

### BACKGROUND

Light source excites the phosphor by laser to generate fluorescence which mixes with laser to generate white light, which is conducive to realizing the miniaturization and integration of laser lighting, and is applicable to fields such as flashlights and laser vehicle lamp lighting.

At present, a laser chip and a wavelength conversion device are generally provided in the same closed space by the light source, so as to realize the excitation of fluorescence and the synthesis of laser fluorescence. However, during the fluorescence excitation process, the wavelength conversion device generates a large amount of heat. After long-time operation, the wavelength conversion device has the risk of damage. Since the laser chip and the wavelength conversion device are arranged in the same closed space, it is difficult to separately maintain and replace the wavelength conversion device, and the entire light source is generally directly discarded, resulting in waste.

### SUMMARY

Embodiments of the present disclosure provide a light source to at least partially improve the above problems.

The embodiments of the present disclosure are implemented using the following technical solutions.

An embodiment of the present disclosure provides a light source, including: an excitation light source and a wavelength conversion device. The excitation light source includes a housing, a laser chip and a beam guiding element. The housing forms a packaging cavity, the packaging cavity includes a light outlet, and the laser chip and the beam guiding element are arranged in the packaging cavity; the laser chip is configured to emit a laser beam; and the beam guiding element is configured to guide the laser beam toward the light outlet. The wavelength conversion device is spaced apart from the housing and arranged on an optical path of the laser beam after exiting the light outlet, and the laser beam is obliquely incident on the wavelength conversion device.

In some embodiments, the beam guiding element is a hemispherical lens.

In some embodiments, the light source further includes: a selective transmission film arranged between the wavelength conversion device and the housing. The laser beam is incident on the selective transmission film after being emitted from the light outlet, and the laser beam is incident on the wavelength conversion device after being emitted from the selective transmission film.

In some embodiments, the wavelength conversion device includes: a substrate and a fluorescent layer. The selective transmission film is arranged on the substrate and located on a light-entering surface of the wavelength conversion device. The fluorescent layer is arranged on the substrate and located on a light-exiting surface of the wavelength conversion device.

In some embodiments, the housing includes a base, a side housing and a top cover, the side housing surrounds the base, the top cover is connected to an end of the side housing away from the base, the base, the side housing and the top cover jointly surround to form the packaging cavity, the light outlet is formed in the top cover, and the excitation light source and the beam guiding element are arranged on the base.

In some embodiments, the top cover is provided with an anti-reflection film that is located on a light-exiting surface of the top cover.

In some embodiments, the light source further includes: a Zener diode arranged in the packaging cavity and connected in series with the laser chip.

In some embodiments, a plurality of laser chips are provided, a plurality of beam guiding elements are provided, the plurality of beam guiding elements are arranged in one-to-one correspondence with the plurality of laser chips, and laser light emitted by each of the laser chips is guided by one of the beam guiding elements to converge on the wavelength conversion device.

In some embodiments, the light source further includes: a diffusion sheet arranged between the wavelength conversion device and the housing and located on a light-exiting path of the laser light.

In some embodiments, the light source further includes: a collection lens arranged on an optical path of the laser beam after exiting the wavelength conversion device.

According to the light source provided by the embodiments of the present disclosure, the wavelength conversion device is arranged separately from the excitation light source, and the housing of the excitation light source is spaced apart from the wavelength conversion device. The laser beam emitted from the excitation light source is obliquely incident on the wavelength conversion device. In this way, the heat concentration of the entire wavelength conversion device can be reduced, and it is convenient for maintenance personnel to maintain and replace the damaged wavelength conversion device after long-time operation of the light source, thereby avoiding the waste caused by directly discarding the entire light source after the wavelength conversion device is damaged.

### BRIEF DESCRIPTION OF DRAWINGS

In order to more clearly illustrate the technical solutions in the embodiments of the present disclosure, the drawings required in the description of the embodiments will be briefly described below. It is clear that, the drawings in the following description are only some embodiments of the present disclosure, and for those skilled in the art, other drawings may also be obtained according to these drawings without any creative effort.
FIG. 1 shows a cross-sectional view of a light source according to an embodiment of the present disclosure;
FIG. 2 shows a cross-sectional view of another light source according to an embodiment of the present disclosure;
FIG. 3 shows a schematic structural diagram of another light source according to an embodiment of the present disclosure; and
FIG. 4 shows a cross-sectional view of another light source according to an embodiment of the present disclosure.

Reference signs: light source 1, excitation light source 10, housing 110, base 111, side housing 112, top cover 113, laser chip 120, beam guiding element 130, packaging cavity 140, light outlet 150, wavelength conversion device 20, substrate 210, fluorescent layer 220, collection lens 30, anti-reflection film 40, Zener diode 50, diffusion sheet 60, heat sink 70, and selective transmission film 80.

### DESCRIPTION OF EMBODIMENTS

To make those skilled in the art better understand the solutions of the present disclosure, the technical solutions in the embodiments of the present disclosure will be clearly and completely described below with reference to the drawings in the embodiments of the present disclosure. Obviously, the described embodiments are only some rather than all of the embodiments of the present disclosure. All other embodiments obtained by those skilled in the art based on the embodiments of the present disclosure without creative efforts should fall within the protection scope of the present disclosure.

The technical solutions in the embodiments of the present disclosure will be clearly and completely described below in combination with the drawings in the embodiments of the present disclosure.

Light source excites the phosphor through laser to generate fluorescence which mixes with laser to generate white light, which is conducive to realizing the miniaturization and integration of laser lighting, and is applicable to fields such as flashlights and laser vehicle lamp lighting.

At present, a laser chip and a wavelength conversion device are generally provided in the same closed space by the light source, so as to realize the excitation of fluorescence and the synthesis of laser fluorescence. However, during the fluorescence excitation process, the wavelength conversion device generates a large amount of heat. After long-time operation, the wavelength conversion device has the risk of damage. Since the laser chip and the wavelength conversion device are arranged in the same closed space, it is difficult to separately maintain and replace the wavelength conversion device, and the entire light source is generally directly discarded, resulting in waste.

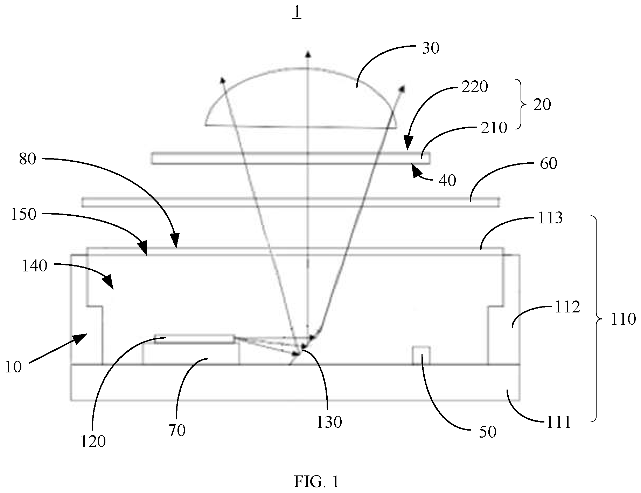

Based on the above technical problem, the present disclosure provides a light source 1. Referring to FIG. 1, which shows a cross-sectional view of a light source 1 according to an embodiment of the present disclosure, the light source 1 may include: an excitation light source 10, a wavelength conversion device 20, and a collection lens 30.

The excitation light source 10 may include a housing 110, a laser chip 120 and a beam guiding element 130. The housing 110 forms a packaging cavity 140. The packaging cavity 140 includes a light outlet 150. The laser chip 120 and the beam guiding element 130 are arranged in the packaging cavity 140. The laser chip 120 is configured to emit a laser beam, and the beam guiding element 130 is configured to guide the laser beam toward the light outlet 150.

Continuing to refer to FIG. 1, in an embodiment, the housing 110 may include: a base 111, a side housing 112, and a top cover 113. The side housing 112 surrounds the base 111. The top cover 113 is connected to an end of the side housing 112 away from the base 111. The base 111, the side housing 112 and the top cover 113 jointly surround to form the packaging cavity 140. The light outlet 150 is formed in the top cover 113. The excitation light source 10 and the beam guiding element 130 are arranged on the base 111.

In an embodiment, the base 111 may be a rectangular plate, and four side housings 112 may be provided. The four side housings 112 are respectively connected to four sides of the base 111. In a more specific embodiment, the side housings 112 may be configured to have a consistent structure in shape and size to facilitate mold opening and production. Further, the base 111 may be integrally formed with the side housings 112, which can simplify the mounting of the housing 110.

The base 111 and the side housing 112 may be made of a plastic material, which is low in cost and good in insulation, and may also be made of a metal material, which is good in chemical corrosion resistance and high in strength. The specific material may be selected according to actual conditions, which is not limited herein.

The top cover 113 may also be a rectangular plate structure. The top cover 113 may cover the side housings 112. In some embodiments, the size of the top cover 113 may be slightly larger than the size of the base 111, so as to ensure that the top cover 113 can completely close the side housings 112, and avoid the external environment affecting elements inside the packaging cavity 140 such as the laser chip 120 and the beam guiding element 130, thereby ensuring that the elements inside the packaging cavity 140 operate normally.

In an embodiment, the light outlet 150 may be the entire top cover 113, and the top cover 113 may be a light-transmitting window. For example, in some embodiments, the entire top cover 113 may be a light-transmitting region. In other embodiments, only a partial region of the top cover 113 may be configured as the light-transmitting window, which is not limited herein.

The connection manner between the top cover 113 and the side housing 112 is not limited in the embodiments of the present disclosure. For example, the connection portion between the top cover 113 and the side housing 112 may be subjected to fusion bonding to satisfy airtightness requirements within the packaging cavity 140.

Further, continuing to refer to FIG. 1, in an embodiment, the top cover 113 may further be provided with an anti-reflection film 40 (light enhancing film), and the anti-reflection film 40 may be located on a light-exiting surface of the top cover 113. In an embodiment, the anti-reflection film 40 may increase the transmittance of blue light, which is conducive to improving the excitation efficiency of blue laser on the wavelength conversion device 20, and further is conducive to improving the brightness of white light.

It may be understood that, in other embodiments, the anti-reflection film 40 may also be arranged on the top cover 113 and cover the light outlet 150. Similarly, such arrangement can also improve the excitation efficiency of blue laser on the wavelength conversion device 20, and further is conducive to improving the brightness of white light.

It should be noted that the arrangement manner of the laser chip 120 is not limited in the embodiments of the present disclosure. Continuing to refer to FIG. 1, in some embodiments, the light source 1 may further include a heat sink 70. The heat sink 70 may be arranged on the base 111, and the laser chip 120 may be arranged on the heat sink 70, for example, may be attached to the heat sink 70.

The heat sink 70 may be made of an aluminum nitride ceramic material, which has good thermal conductivity. The heat sink 70 is provided between the laser chip 120 and the base 111, and may be configured to efficiently conduct heat generated by the operation of the laser chip 120 to the housing 110, so as to improve the heat dissipation efficiency.

In addition, in some embodiments, the surface of the heat sink 70 may be an inclined surface, which may also function to change the position and direction of the laser light emitted by the laser light source 120. The height and shape of the heat sink 70 are not limited in the embodiments of the present disclosure, which may be specifically configured according to actual conditions.

In addition, the color of the laser beam emitted by the laser chip 120 is not limited in the embodiments of the present disclosure. The following description is made by taking the laser chip 120 emitting blue laser as an example.

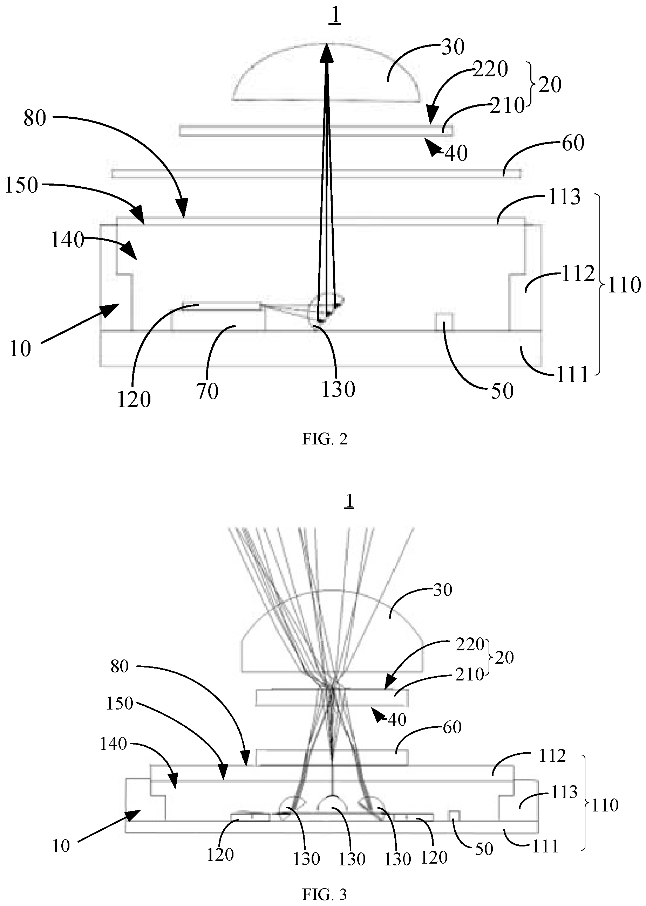

Referring to FIG. 2, in an embodiment, the beam guiding element 130 is arranged on an optical path of the laser beam emitted by the laser chip 120, and is configured to change a traveling direction of the laser beam. For example, the laser chip 120 emits the laser beam in a horizontal direction relatively parallel to the upper surface of the base 111, and the beam guiding element 130 changes the traveling direction of the laser beam to travel upward, so as to emit upward through the light outlet 115 of the top cover 113. In this way, the space in the horizontal direction and the vertical direction of the packaging cavity 114 is simultaneously utilized, which is conducive to reducing the overall volume.

The specific structure of the beam guiding element 130 is not limited in the embodiments of the present disclosure. For example, the beam guiding element 130 may be configured as an optical element or a combination of optical elements that can change a beam direction, such as a reflector, a prism, or an optical guide.

In the examples shown in FIG. 2 to FIG. 4, the beam guiding element 130 may be configured as a hemispherical lens. For example, the hemispherical lens may be configured as follows: the plane of the hemispherical lens is a reflective surface, and is arranged obliquely relative to the upper surface of the base 111. A part of the hemispherical surface in the hemispherical lens faces the laser chip 120 to receive the laser beam from the laser chip 120. Another part of the hemispherical surface of the hemispherical lens faces the light outlet 115 of the top cover 113. In this way, the laser beam enters the interior of the hemispherical lens through a part of the hemispherical surface of the hemispherical lens and is refracted, then the laser beam is reflected by the plane of the hemispherical lens to change the traveling direction, and finally the laser beam is emitted toward the light outlet 115 of the top cover 113 through another part of the hemispherical lens and is refracted again. Since the laser beam undergoes two refractions on the hemispherical surface of the hemispherical lens, it is equivalent to that the hemispherical lens produces the effect on the laser beam by the hemispherical lens, that is, changing the originally divergent laser beam into a convergent laser beam. The convergence point of the laser beam may be configured on the wavelength conversion device 20, so as to increase the central brightness of the emitted light.

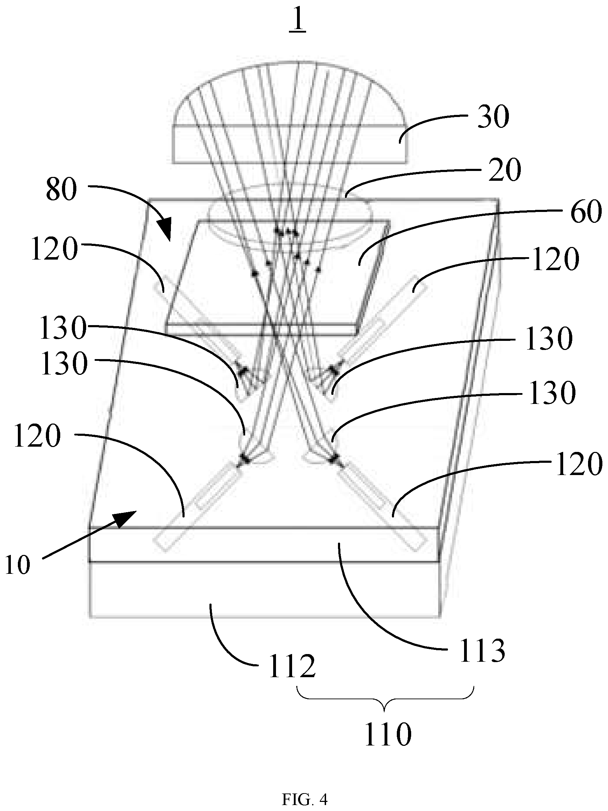

Referring to FIG. 3 and FIG. 4, further, in some embodiments, a plurality of laser chips 120 may be provided, and a plurality of beam guiding elements 130 may also be provided. The plurality of beam guiding elements 130 are arranged in one-to-one correspondence with the plurality of laser chips 120. The laser light emitted from the laser chips 120 is obliquely incident to the same region of the wavelength conversion device 20, so that a plurality of at least partially overlapping light spots may be formed in the same region of the wavelength conversion device 20, thereby significantly improving the brightness of the light source 1.

For example, as shown in FIG. 4, four laser chips 120 may be provided. Each laser chip 120 may be respectively arranged at the corner of the packaging cavity 140, and each laser chip 120 may be connected in series. Four beam guiding elements 130 may be fixed by a fixing frame, so that the angle of each beam guiding element is consistent. The laser light emitted by each laser chip 120 is guided by one beam guiding element 130 to converge on the wavelength conversion device 20, which is conducive to improving the brightness of the light source 1.

The wavelength conversion device 20 is spaced apart from the housing 110 and corresponds to the light outlet 150. The laser beam emitted by the excitation light source 10 may emit from the light outlet 150 after passing through the beam guiding element 130, and be incident into the wavelength conversion device 20.

The specific structure of the wavelength conversion device 20 is not limited in the embodiments of the present disclosure. The wavelength conversion device 20 may be a fluorescent sheet, a grating wavelength meter, a spectrometer, a color wheel, etc., which is not limited herein, and may be specifically configured according to actual conditions. Continuing to refer to FIG. 1 and FIG. 2, for example, in an embodiment, the wavelength conversion device 20 may include: a substrate 210 and a fluorescent layer 220.

For example, the fluorescent layer 220 may be arranged on the substrate 210. The laser beam may be excited into a fluorescent beam after irradiating the fluorescent layer 220. The arrangement manner of the fluorescent layer 220 is not limited in the embodiments of the present disclosure. For example, the fluorescent layer 220 may be directly sintered on the substrate 210. In some embodiments, the fluorescent layer 220 may be made of rare earth-doped inorganic materials, such as ytterbium and erbium co-doped yttrium fluoride, sodium yttrium fluoride, and lanthanum fluoride, which may be specifically configured according to actual conditions and is not limited herein.

For example, the fluorescent layer 220 may be arranged on a surface of the substrate 210 away from the housing 110. In an embodiment, the fluorescent layer 220 may be provided with yellow phosphor. After the blue laser is incident on the wavelength conversion device 20, the blue laser excites the yellow phosphor in the fluorescent layer 220 to generate yellow excited light (fluorescent light). The yellow excited light is mixed with the blue laser that is not completely converted, so as to form white light.

In other embodiments, the wavelength conversion device may further include a functional layer. The functional layer may be arranged on the surface of the fluorescent layer 220. The functional layer may be an electron transport layer, a hole transport layer, a protective layer, or the like. The electron transport layer is generally made of some materials having relatively high conductivity and thermal stability, such as oxide, and nitride. The function of the electron transport layer is to transmit excited-state electrons to the light emitting layer, thereby generating fluorescence. The hole transport layer is generally made of some materials having relatively high thermal stability and chemical stability, such as nitride, and silicide. The function of the hole transport layer is to transport holes in the light emitting layer to the light emitting layer, thereby realizing light emission. The protective layer is generally made of some materials having relatively high thermal stability and chemical stability, such as silicide, and nitride. The function of the protective layer is to protect the phosphor from being affected by environmental factors, and prolong the service life of the phosphor. It should be noted that the specific structure and composition of the wavelength conversion device 20 are not limited in the embodiments of the present disclosure, and a user may select a suitable wavelength conversion device 20 according to actual requirements.

The collection lens 30 may be arranged on a side of the wavelength conversion device 20 away from the excitation housing 110. The collection lens 30 may be configured to converge the white laser emitted from the wavelength conversion device 20. The specific focal length and size of the collection lens 30 is not limited in the embodiments of the present disclosure, which may be specifically selected according to actual conditions.

According to the light source 1 provided by the embodiments of the present disclosure, the wavelength conversion device 20 is arranged separately from the excitation light source 10, and the housing 110 of the excitation light source 10 is spaced apart from the wavelength conversion device 20. The laser beam emitted from the excitation light source 10 is obliquely incident on the wavelength conversion device 20. In this way, the heat concentration of the entire wavelength conversion device 20 can be reduced, and it is convenient for maintenance personnel to maintain and replace the damaged wavelength conversion device 20 after long-time operation of the light source 1, thereby avoiding the waste caused by directly discarding the entire light source 1 after the wavelength conversion device 20 is damaged.

Further, continuing to refer to FIG. 1, in an embodiment, the light source 1 may further include: a selective transmission film 80 that may be arranged between the wavelength conversion device 20 and the housing 110. After being emitted from the light outlet 115 of the top cover 113, the laser beam is incident on the selective transmission film 80, and after being emitted from the selective transmission film 80, the laser beam is incident on the wavelength conversion device 20.

In an embodiment, the selective transmission film 80 may be a film layer that transmits blue light and reflects yellow light. Since the excited light generated during the excitation of the laser beam in the wavelength conversion device 20 is light uniformly emitted at 360 degrees, the selective transmission film 80 may enable the laser beam to be incident on the wavelength conversion device 20 and enable the excited light to be emitted from one side thereof.

In addition, referring to FIG. 1 again, in some embodiments, the light source 1 may further include a Zener diode 50 that may be arranged in the packaging cavity 140. For example, the Zener diode 50 may be arranged on the base 111 and connected in series with the laser chip 120. The Zener diode 50 may play an anti-static role, so as to protect the laser chip 120 and prevent the laser chip 120 from being damaged by static electricity.

Referring to FIG. 3, in some embodiments, the light source 1 may further include a diffusion sheet 60. The diffusion sheet 60 may be arranged between the wavelength conversion device 20 and the housing 110 and located on the light-exiting path of the laser light. For example, the diffusion sheet 60 may be directly arranged on the top cover 112. The diffusion sheet 60 may uniformly diffuse the blue laser emitted by the laser chip 120, so as to better excite the fluorescent layer 220 to generate white light. In addition, the diffusion sheet 60 may also adjust the angle of the laser beam to achieve diffusion effects at different angles, which may be specifically configured according to actual conditions and is not limited herein.

Further, in an embodiment, the light source 1 may further include a bracket (not shown in the drawings). The collection lens 30, the wavelength conversion device 20, and the diffusion sheet 60 may be arranged on the bracket and integrated into a whole, which can more conveniently control the gap between the whole of the collection lens 30, the wavelength conversion device 20, and the diffusion sheet 60 and the housing 110. The bracket may be separated from the housing 110, and may be detachably connected to the housing 10. For example, the bracket may be fixed together with the housing 10 by screws.

In addition, the collection lens 30, the wavelength conversion device 20, and the diffusion sheet 60 may also be detachably connected to the bracket, which can further facilitate maintenance personnel to replace the collection lens 30, the wavelength conversion device 20, and the diffusion sheet 60.

The following is the working principle of the light source 1 according to the embodiments of the present disclosure.

Referring to FIG. 2, taking the light source 1 in FIG. 2 as an example for description, after the laser chip 120 is energized, the laser chip 120 emits a blue laser beam. After irradiating the beam guiding element 130, the blue laser is emitted toward the light outlet 150 of the packaging cavity 140. After passing through the light outlet 150, the blue laser is incident on the anti-reflection film 40, and then is emitted from the anti-reflection film 40. After being diffused by the diffusion sheet 60, the blue laser enters the selective transmission film 80. After passing through the selective transmission film 80, the blue laser irradiates the wavelength conversion device, and reacts with the fluorescent layer to excite yellow fluorescence. The yellow fluorescence and the unexcited blue laser are combined to form white light. Finally, the white light is emitted toward the collection lens 30 and collected by the collection lens 30.

As above, in the light source 1 according to the embodiments of the present disclosure, by providing the selective transmission film 80, the film layer has selective transmittance for the laser light emitted from the excitation light source 10 and reflectivity for the excited light. The laser light is partially converted into the excited light under the action of the wavelength conversion device 20, and the excited light directed toward a direction of the excitation light source 10 is reflected under the action of the selective transmission film, so as to improve the utilization rate of the excited light. However, since an oblique angle is formed between the laser light and the selective transmission film 80, when the angle is too large, the selective transmission film 80 reflects the incident laser light, which causes the utilization rate of the laser light to decrease. In this case, the wavelength conversion device 20 is arranged separately from the excitation light source 10, which can reduce the oblique incidence angle of the laser light emitted by the excitation light source 10, thereby improving the utilization rate of the laser light. In addition, the housing 110 of the excitation light source 10 is spaced apart from the wavelength conversion device 20, which can also reduce the volume of the excitation light source 10 and reduce the heat concentration of the entire wavelength conversion device 20. In this way, different wavelength conversion devices 20 can be replaced according to different application scenarios, and it is convenient for maintenance personnel to maintain and replace the damaged wavelength conversion device 20 after long-time operation of the light source 1, thereby avoiding the waste caused by directly discarding the entire light source 1 after the wavelength conversion device 20 is damaged.

In the present disclosure, unless otherwise explicitly specified or defined, terms such as "mounting" and "connection" should be understood in a broad sense. For example, it may be a fixed connection, a detachable connection, an integral connection, or a transmission connection. It may be a direct connection, or an indirect connection through an intermediate medium. For those of ordinary skill in the art, specific meanings of the above terms in the present disclosure may be understood based on specific situations.

In addition, terms such as "first" and "second" are merely used to distinguish description, and cannot be understood as referring to specific or special structures. The description of the term "some embodiments" means that particular features, structures, materials, or characteristics described in conjunction with the embodiments or examples are included in at least one embodiment or example of the present disclosure. In the present disclosure, the schematic expressions of the above terms are not necessarily directed to the same embodiment or example. In addition, the described specific features, structures, materials, or characteristics described can be combined in an appropriate way in any one or more embodiments or examples. In addition, those skilled in the art may combine and associate different embodiments or examples described in the present disclosure and features of different embodiments or examples, without conflicting with each other.

The above embodiments are only used to illustrate the technical solutions of the present disclosure, but not to limit the same. Although the present disclosure has been described in detail with reference to the above embodiments, a person of ordinary skill in the art should understand that: the technical solutions described in the above embodiments may still be modified, or some technical features thereof may be equivalently replaced. These modifications or substitutions do not make the essence of the corresponding technical solutions depart from the spirit and scope of the technical solutions of the embodiments of the present disclosure, and should all fall within the protection scope of the present disclosure.

## Claims

1. A light source, comprising:
an excitation light source comprising a housing, a laser chip and a beam guiding element, wherein the housing forms a packaging cavity, the packaging cavity has a light outlet, and the laser chip and the beam guiding element are provided in the packaging cavity; the laser chip is configured to emit a laser beam; and the beam guiding element is configured to guide the laser beam toward the light outlet; and
a wavelength conversion device, wherein the wavelength conversion device is spaced apart from the housing and provided in an optical path of the laser beam after exiting the light outlet, and the laser beam is obliquely incident on the wavelength conversion device.

2. The light source according to claim 1, wherein the beam guiding element is a hemispherical lens.

3. The light source according to claim 1, further comprising: a selective transmission film provided between the wavelength conversion device and the housing, wherein the laser beam, after exiting the light outlet, is incident on the selective transmission film; and after exiting the selective transmission film, the laser beam is incident on the wavelength conversion device.

4. The light source according to claim 3, wherein the wavelength conversion device comprises:
a substrate, wherein the selective transmission film is provided on the substrate and located on a light-entering surface of the wavelength conversion device; and
a fluorescent layer provided on the substrate and located on a light-exiting surface of the wavelength conversion device.

5. The light source according to claim 1, wherein the housing comprises a base, a side housing and a top cover, the side housing surrounds the base, the top cover is connected to an end of the side housing away from the base, wherein the base, the side housing and the top cover jointly surround to form the packaging cavity, the light outlet is formed in the top cover, and the excitation light source and the beam guiding element are provided on the base.

6. The light source according to claim 5, wherein the top cover is provided with an anti-reflection film that is located on a light-exiting surface of the top cover.

7. The light source according to claim 5, further comprising: a Zener diode provided in the packaging cavity and connected in series with the laser chip.

8. The light source according to claim 1, wherein a plurality of laser chips and a plurality of beam guiding elements are provided, the plurality of beam guiding elements are in one-to-one correspondence with the plurality of laser chips, and laser light emitted by each of the plurality of laser chips is guided by a corresponding beam guiding element of the plurality of beam guiding elements to converge on a same region of the wavelength conversion device.

9. The light source according to claim 1, further comprising: a diffusion sheet provided between the wavelength conversion device and the housing and located in an optical path of the laser light.

10. The light source according to claim 1, further comprising: a collection lens provided in an optical path of the laser beam after exiting the wavelength conversion device.
